(19) Europäisches Patentamt
European Patent Office
Office européen des brevets

(11) **EP 1 047 199 B1**

(12) **EUROPÄISCHE PATENTSCHRIFT**

(45) Veröffentlichungstag und Bekanntmachung des Hinweises auf die Patenterteilung:
**15.12.2004   Patentblatt 2004/51**

(51) Int Cl.⁷: **H03M 13/35**, H03M 13/17

(21) Anmeldenummer: **00107367.5**

(22) Anmeldetag: **05.04.2000**

(54) **Datenübertragungsvorrichtung und -verfahren**

Data transmission device and method

Dispositif et méthode de transmission de données

(84) Benannte Vertragsstaaten:
**DE FR GB IT**

(30) Priorität: **23.04.1999   DE 19918507**

(43) Veröffentlichungstag der Anmeldung:
**25.10.2000   Patentblatt 2000/43**

(73) Patentinhaber: **ROBERT BOSCH GMBH**
**70442 Stuttgart (DE)**

(72) Erfinder: **Adi, Wael**
**38108 Braunschweig (DE)**

(56) Entgegenhaltungen:
**US-A- 3 811 108          US-A- 5 381 423**

- **"FIRE-CODE DECODING" IBM TECHNICAL DISCLOSURE BULLETIN, IBM CORP. NEW YORK, US, Bd. 31, Nr. 7, 1. Dezember 1988 (1988-12-01), Seiten 332-335, XP000022440 ISSN: 0018-8689**
- **LIN S. AND COSTELLO D.: "Error Control Coding: Fundamentals and Applications" 1983 , PRENTICE HALL , ENGLEWOOD CLIFFS, NJ, USA XP002229620 * Seite 257 - Seite 269 ***
- **CHIEN R T: "Burst-correcting codes with high-speed decoding" IEEE TRANSACTIONS ON INFORMATION THEORY, JAN. 1969, USA, Bd. IT-15, Nr. 1, Seiten 109-113, XP002229415 ISSN: 0018-9448**

**Beschreibung**

STAND DER TECHNIK

Die vorliegende Erfindung betrifft eine Datenübertragungsvorrichtung zur Durchführung einer VRC-Datenübertragungstechnik (VRC = Variable Redundancy Codes) sowie ein entsprechendes Datenübertragungsverfahren.

Obwohl auf beliebige Datenübertragungstechniken anwendbar, werden die vorliegende Erfindung sowie die ihr zugrundeliegende Problematik in bezug auf ein UMTS-System (Universal Mobil Telecommunication System erläutert.

Aus der US 3,811,108 ist ein Verfahren und eine Vorrichtung bekannt, bei der eine umkehrbare zyklische Codierung verwendet wird, um eine umgekehrte Fehleridentifikation zu ermöglichen. Codierung und Decodierung wird im wesentlichen in herkömmlicher Weise durchgeführt mit Ausnahme, dass die Codierung mittels eines reversiblen zyklischen Generatorpolynoms durchgeführt wird. Dazu wird ein lineares rückgekoppeltes Schieberegister mit logischen Gattern versehen, die die Umkehrung eines Syndroms für aufeinander folgende Fehleridentifikation ermöglichen.

Aus der IBM Technical Disclosure Bulletin, Vol.31, No.7, December 1988, Armonk, NY, USA ist eine Fire-Code Decodierungstechnik bekannt, die die Anzahl der Gatter reduzieren kann, indem ein Generatorpolynom zur Detektion der Fehlerposition verwendet wird.

Die Technik der Variable Redundancy Codes erlaubt es, die Länge der durch die Kanalcodierung eingefügten Redundanz dynamisch zu verändern. Diese Eigenschaft ist besonders in Übertragungskanälen mit (zeitlich) variabler Blocklänge der Quell- und/oder Kanaldaten (siehe z. B. UMTS (xx04 V0.5.0, UTRA FDD, multiplexing, channel coding and interleaving description) von Vorteil.

Aus Error Control Coding, Fundamentals and Applications, Shu Lin / Daniel J. Castello jr., 1983 und aus Error correcting and detecting Codes, W.W. Peterson and Weldon, MIT Press, 1996 ist allgemein die Verwendung von Fire Codes bekannt, die dem VRC zugrundeliegen.

Sei z.B. k die Länge eines Quelldatenblocks, die durch den Benutzer fest vorgegeben wird, und n die Gesamtlänge eines Codeblocks, die durch technische Gegebenheiten z.B. des Übertragungskanals dynamisch schwanken kann, so kann die Länge r der Redundanz vom Benutzer dynamisch definiert werden, um den geforderten Wert für n = k + r zu erzielen. Dies geschieht beispielsweise durch Veränderung des Code-Parameters c im Fire-Code-Generatorpolynom G(x), das definiert ist durch:

$$G(x) = (1+x^c)^{.} P(x) \tag{1}$$

Die hier eingesetzten Fire Codes sind besonders durch ihre Fähigkeit, Bündelfehler erkennen und/oder korrigieren zu können, gekennzeichnet. Die Decodierung Bündelfehlerkorrigierender Codes wird meist, wie in Error Control Coding, Fundamentals and Applications, Shu Lin / Daniel J. Castello jr., 1983 dargestellt, mittels der "errortrapping"-Technik implementiert.

e sei die Periode des irreduziblen Polynoms $P(x)$ vom Grad m, wobei gilt $e \leq 2^m - 1$. Die Periode e des Polynoms $P(x)$ bestimmt in Verbindung mit c die Länge des gewählten Codes, d.h. die Länge eines (nicht verkürzten) Fire-codierten Datenpakets ist auf maximal $n_0 = k_0 + r_0 = KGV\{e^{.}c\}$ beschränkt (KGV = Kleinstes Gemeinsames Vielfaches).

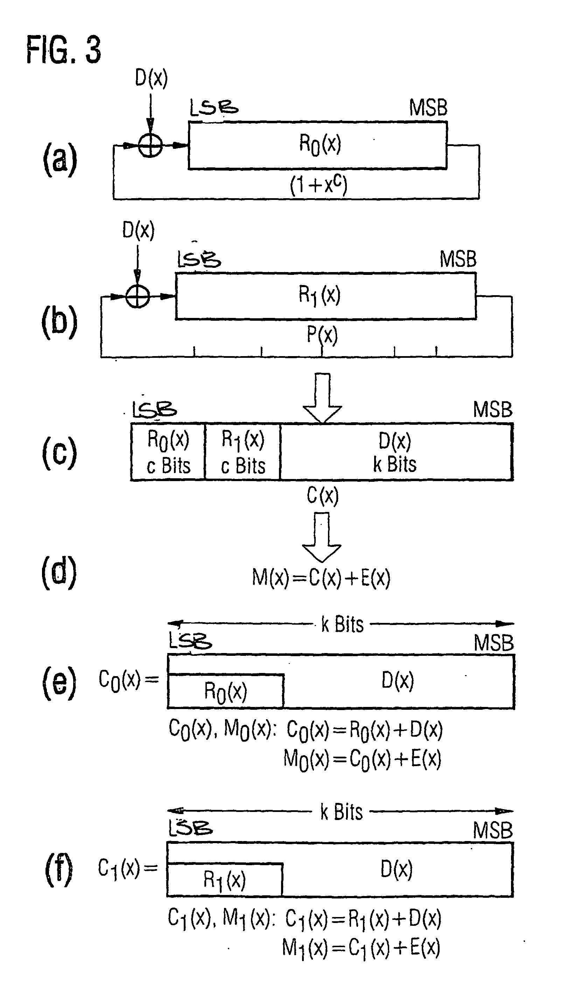

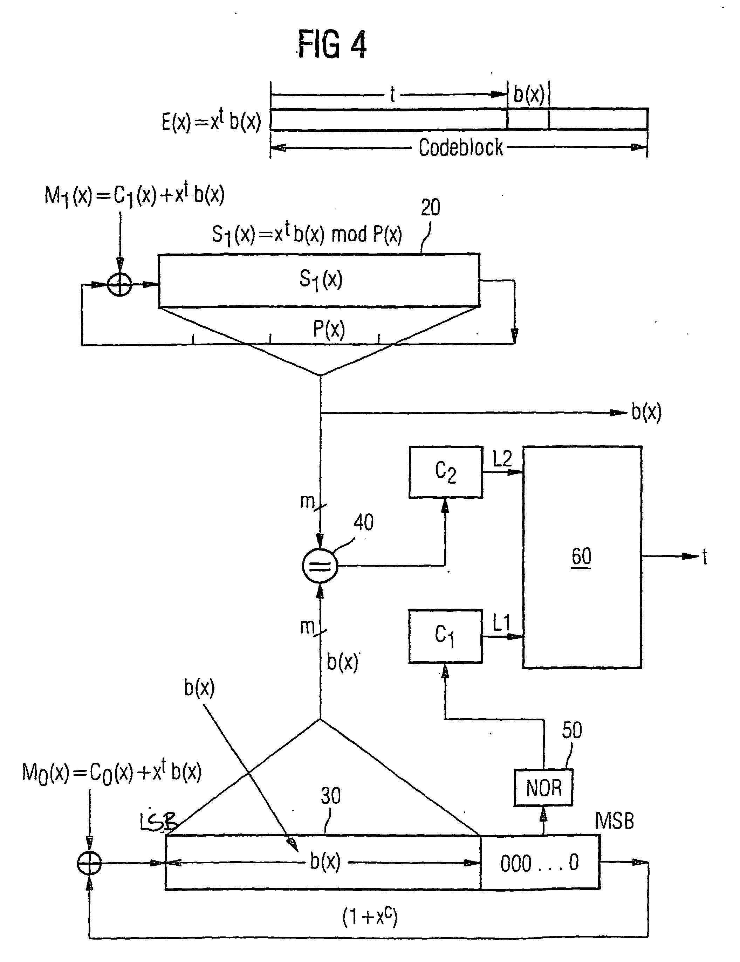

Nachstehend wird zunächst anhand von Fig. 3 eine schematische Darstellung eines üblichen Codierverfahrens mit anschließender Datenübertragung der codierten Daten erläutert. Anschließend wird anhand von Fig. 4 eine schematische Darstellung eines üblichen Decodierverfahrens entsprechend dem Codierverfahren nach Fig. 3 erläutert.

Aus Error Control Coding, Fundamentals and Applications, Shu Lin / Daniel J. Castello jr., 1983 und Error correcting and detecting Codes, W.W. Peterson and Weldon, MIT Press, 1996 kann entnommen werden, daß ein an der Decodiereinrichtung empfangenes Signal M(x) als eine Addition des gesendeten Codeworts C(x) mit einem Fehlerbündel E(x) dargestellt werden kann, also gilt

$$M(x) = C(x) + E(x) \tag{2}$$

Das Fehlerbündel E(x) sei nun definiert als

$$E(x) = x^t b(x) \tag{3}$$

Dieses Fehlerbündel E(x) teilt sich also auf in ein Fehlerbündelmuster (error burst pattern) b(x) und eine Fehlerposition (error position) t dieses Musters b(x) vom Anfang des Codeblocks.

Fig. 3(c) zeigt das Schema zur Generierung vom gesendeten Codewort C(x) aus den k Datenbits D(x) und den beiden Redundanzen $R_0(x)$ mit c Bits aus Fig. 3(a) und $R_1(x)$ mit m Bits aus Fig. 3(b).

Das gesendete Codewort C(x) mit k+c+m Bits kann gestört werden durch Fehler E(x) vom Übertragungskanal und als M(x) = C(x) + E(x) mit k+c+m Bits empfangen, wie in Fig. 3(d) angedeutet.

Der Empfänger konstruiert aus M(x) die beiden Teilcodewörter $C_0(x)$ = D(x) + $R_0(x)$ mit k Bits bzw. $C_1(x)$ = D(x) + $R_1(x)$ mit k Bits oder die gestörten Codewörter $M_0(x)$ = $C_0(x)$ + E(x) mit k Bits bzw. $M_1(x)$ = $C_1(x)$ + E(x) auch mit k Bits, wie in Fig. 3(e) bzw. Fig. 3(f) gezeigt ist. Die beiden gestörten Teil-Codewörter $M_0(x)$ und $M_1(x)$ mit jeweils k Bits stehen der Decodiereinrichtung auf der Empfängerseite als Eingabedaten zur Weiterverarbeitung bereit.

Alternativerweise kann die Codierung unter Verwendung eines einzigen Redundanzwortes R(x) durchgeführt werden. Damit können Fehler im Redundanzbit ebenfalls korrgiert werden.

Übliche Fehlerortungsverfahren, wie in Error Control Coding, Fundamentals and Applications, Shu Lin / Daniel J. Castello jr., 1983 beschrieben, berechnen das Fehlerbündelmuster b(x) und den Fehlerort (error position) t durch Ermittlung von t = $n_0$-q. Hierbei ist q der Abstand des Fehlerbündels vom Ende des Codeblocks.

Diese Art der Ermittlung von t erfordert nachteilhafterweise Multiplikations-, Divisions- und Additionsoperationen. Daher wird dieses Verfahren sehr komplex, sobald das Generatorpolynom (d.h. der Wert von c) und die Datenlänge k variabel realisiert werden sollen. Beide Parameter c und k sind stark in den notwendigen Berechnungen involviert.

Fig. 4 zeigt in schematischer Darstellung eine solche übliche Decodieranordnung, welche in Example 9.2 in Error Control Coding, Fundamentals and Applications, Shu Lin / Daniel J. Castello jr., 1983 näher erläutert ist.

Insbesondere bedient sich die bekannte Decodieranordnung zweier Register 20, 30 für $S_1(x)$ = $x^t$b(x) mod P(x) bzw. b(x), einer Vergleichseinrichtung 40, eines ersten und zweiten Zählers C1 bzw. C2, eines NOR-Gatters 50 sowie einer Recheneinrichtung 60 zur Ermittlung von t durch Multiplikations-, Divisions- und Additionsoperationen abhängig von k, c sowie L1, L3, den Zählwerten von C1 bzw C2.

VORTEILE DER ERFINDUNG

Die erfindungsgemäße Datenübertragungsvorrichtung mit den Merkmalen des Anspruchs 1 und das entsprechende Datenübertragungsverfahren gemäß Anspruch 5 weisen gegenüber den bekannten Lösungsansätzen den Vorteil auf, daß sie eine besonders schnelle und einfache Implementierung der Codier-/Decodiervorrichtungen für einen solchen VRC-Code bieten, die besonders geeignet ist für Bündelfehler-korrigierende Codes mit variabler Redundanz- und/oder Datenlänge.

Die hier beschriebene Realisierung der Codier-/ Decodiereinrichtung für VRC bietet Möglichkeiten, die Fehlererkennungs- bzw. -korrekturfähigkeit des dem VRC zugrundeliegenden Fire Codes flexibel auszunutzen.

Die der vorliegenden Erfindung zugrundeliegende Idee besteht darin, daß sie sich einer Spiegelungstechnik bedient. Das Syndrom-Muster S(x) wird in seiner Spiegelbildversion S˜(x) für eine besonders einfache und Codelängen-unabhängige Ermittlung der Fehlerbündelposition t genutzt. In diesem Vorgang wird das Spiegelbild von P(x), also $P^*(x)$, zur Beschaltung des Suchregisters herangezogen. Dadurch wird der Ort t des Fehlermusters identifiziert. Diese Suche der Fehlerposition benötigt nur t Suchtakte.

Dies ist eine besondere Art von Decodierung, welche die gewünschte einfache dynamische Veränderung der Redundanz und der Codeblocklänge zuläßt. Zudem wird der Prozeß der Fehlerkorrektur durch den Wegfall der Rechenoperationen vereinfacht und beschleunigt.

Der Maximalwert der nutzbaren Codeblocklänge n < $n_0$ sollte hierzu allerdings auf die Periode e des Teilpolynoms P(x) beschränkt werden. Dies ist nötig, um das Reziprok-Polynom $P^*(x)$ = $x^{m \cdot}P(1/x)$ in einer vereinfachten Decodiervorrichtung implementieren zu können und gleichzeitig die dynamische Anpassung der gewünschten Fehlerkorrektur b(x) bei minimaler Anpassung des Codierers und Decodierers zu berücksichtigen.

Die Flexibilität des Codes wird dadurch gewährleistet, daß der Wert für c frei wählbar gestaltet wird, das irreduzible Polynom P(x) und damit der Wert für m jedoch fixiert werden.

Diese Erfindung verzichtet auf komplexe Rechenoperationen. Es werden lediglich elementare Schiebe-, UND-, XOR-, Zähl- und Vergleichsoperationen sowie Spiegelungen von Registerinhalten vorgenommen.

Die Ermittlung der Fehlerposition t ist unabhängig von den (flexiblen) Parametern c und k.

Diese Erfindung erlaubt eine einfache Implementierung von zyklischen VRC-Codes (variable redundancy codes). Die Möglichkeiten der Fehlererkennung und/oder -korrektur von VRCs werden mit geringer Implementierungskomplexität unterstützt.

Die Anzahl der redundanten Bits r kann exakt an die Anforderungen von Quell- und Kanaldatenrate angepaßt werden, ohne daß wesentliche Änderungen der Codier- und Decodier-Architektur notwendig würden.

Die Länge des zu codierenden Datenblocks k kann exakt an die Anforderungen von Quell- und Kanaldatenrate angepaßt werden, ohne daß eine Änderung der Codier-und Decodier-Architektur vorgenommen werden müßte.

Die Technik der Implementierung des VRC-Codes erlaubt einen flexiblen Trade-Off zwischen Fehlererkennung und Fehlerkorrektur. Die Länge erkennbarer Fehlerbüschel kann jederzeit auf Kosten bzw. zu Gunsten sinkender Korrekturfähigkeit flexibel erhöht bzw. gesenkt werden (und umgekehrt), ohne eine Änderung an der Decodier-/Codier-Architektur vornehmen zu müssen.

Die implementierte Fehlerkorrektur und -erkennung ist leicht zu verändern und kann somit an Systemanforderungen und/oder die Güte des Übertragungskanals angepaßt werden.

Somit schafft die Erfindung eine Vorrichtung und ein Verfahren zur Codierung/Decodierung von Codes mit variabler Redundanz (variable redundancy codes, VRC), die es erlaubt, die Länge der durch die Kanalcodierung eingefügten Redundanz r dynamisch zu verändern, die Länge des Datenblocks k dynamisch zu verändern und die sowohl Fehlererkennung als auch -korrektur erlaubt, ohne daß komplexe Rechenoperationen zur Ermittlung des Bündel-Fehlermusters sowie dessen Position im Codeblock benötigt werden.

Dies ist insbesondere nützlich in Übertragungssystemen, die eine dynamische Anpassung der Code-Redundanz r aus technischen Gründen, z. B. bei der Übertragung von Daten variabler Länge über Kanäle mit zeitlichen Veränderungen ihrer Fehlercharakteristik, erfordern.

In den Unteransprüchen finden sich vorteilhafte Weiterbildungen und Verbesserungen der in Anspruch 1 angegebenen Datenübertragungsvorrichtung bzw. des in Anspruch 7 angegebenen Datenübertragungsverfahrens.

Gemäß einer bevorzugten Weiterbildung ist in der Empfangseinrichtung eine Vergleichseinrichtung zum Vergleichen des Fehlermusters mit dem Spiegelbild des Inhalts eines Registers, das mit dem gespiegelten Syndrom vorbelegt ist, wobei das Spiegelbild des Teilpolynoms als Rückkopplung oder Beschaltung des Registers vorgesehen ist, um die Position des Fehlermusters durch den Vergleich zu identifizieren. Somit lässt sich die Ermittlung der Fehlerbündelposition unabhängig von der Codeblocklänge oder anderer Code-Parameter durchführen, und insbesondere eine Veränderung der Länge des Codewortes hat keinen Einfluss auf die oben genannten Vorgänge.

Gemäß einer weiteren bevorzugten Weiterbildung sind in der Empfangseinrichtung ein erstes Schieberegister zum Generieren des Syndroms, und ein zweites Schieberegister zum Generieren eines weiteren Syndroms oder Bitmusters aus dem gespiegelten Syndrom enthalten.

Gemäß einer weiteren bevorzugten Weiterbildung ist das Teilpolynom selbstreziprok, d.h. $P(x) = x^m * P(1/x)$, und ist in der Empfangseinrichtung ein und dasselbe Schieberegister zum Generieren des Syndroms und eines weiteren Syndroms oder Bitmusters aus dem gespiegelten Syndrom enthalten. Diese Implementierung ist hardwaremäßig besonders günstig.

Gemäß einer weiteren bevorzugten Weiterbildung ist die Codiereinrichtung derart gestaltet ist, dass Einschränkung der Länge des Codewortes auf die Länge der Periode des Teilpolynoms vorgesehen ist. Dies trägt dazu bei, weitere Berechnungen zu vermeiden.

Gemäß einer weiteren bevorzugten Weiterbildung ist die Codiereinrichtung derart gestaltet ist, für den Codeparameter c im Fire-Code-Generatorpolynom G(x), das definiert ist durch $G(x) = (1+x^c) * P(x)$, $c \geq 2 * b - 1$ gilt, wobei b die Länge eines Bündelfehlers darstellt, der noch mit Hilfe dieses Codes korrigiert werden kann und maximal den Wert m annehmen kann, wobei m der Grad des Teilpolynoms ist. Da ein Kompromiss zwischen Fehlererkennung d und Fehlerkorrektur b eingegangen werden muss, werden typischerweise kleine Werte für b gewählt, um noch eine vernünftige Fehlererkennung zu gewährleisten.

ZEICHNUNGEN

Ausführungsbeispiele der Erfindung sind in den Zeichnungen dargestellt und in der nachfolgenden Beschreibung näher erläutert.

Es zeigen:

Fig. 1     eine schematische Darstellung eines Decodierverfahrens als Ausführungsbeispiel der vorliegenden Erfindung;

Fig. 2     eine schematische Darstellung eines konkreten Decodierbeispiels für das Decodierverfahrens nach Fig. 1;

Fig. 3     eine schematische Darstellung eines üblichen Codierverfahrens mit anschließender Datenübertragung der codierten Daten; und

Fig. 4     eine schematische Darstellung eines üblichen Decodierverfahrens entsprechend dem Codierverfahren nach Fig. 3.

## BESCHREIBUNG DER AUSFÜHRUNGSBEISPIELE

In den Figuren bezeichnen gleiche Bezugszeichen gleiche oder funktionsgleiche Elemente.

Insbesondere bezeichnen MSB das höchstwertige Bit und LSB das niederwertigste Bit.

Der Codiervorgang auf der Senderseite, wie in Fig. 3 illustriert, läuft folgendermaßen ab.

Die Code-Parameter werden bei diesem Beispiel folgendermaßen eingeschränkt:

1. Das Polynom $P(x)$ wird als irreduzibel vom Grad m und möglichst mit der Periode $e = 2^m - 1$ gewählt.

2. Die verkürzte Codeblocklänge $n = k + r << n_0$ darf den Wert e der Periode von $P(x)$ nicht überschreiten. Diese Einschränkung bringt jedoch in praktischen Anwendungen i.a. keinen Nachteil, da üblicherweise verkürzte Codes benutzt werden, wo $n < e$ gilt.

3. Der Wert c sollte folgender Bedingung genügen: $c \geq 2 \cdot b - 1$, wobei b die Länge eines Bündelfehlers darstellt, der noch mit Hilfe dieses Codes korrigiert werden kann und maximal den Wert m annehmen kann (d.h. $b \leq m$). Da ein Kompromiß zwischen Fehlererkennung d und Fehlerkorrektur b eingegangen werden muß, werden typischerweise kleine Werte für b gewählt, um noch eine vernünftige Fehlererkennung zu gewährleisten. Denn mit d, der Länge der erkennbaren Fehlerbündel eines Datenrahmens, und b, der Länge korrigierbarer Bündelfehler, gilt: $d = c + 1 - b$. D.h., tritt bei der Übertragung eines Datenrahmens ein einziger Bündelfehler in diesem Rahmen auf, so können bis zu d fehlerhafte Bits dieses Bündelfehlers erkannt werden, und der Decodierer wird Bündelfehler mit einer Länge kleiner oder gleich b Bits korrigieren.

Während der Codierung der k Datenbits wird ein gültiges Codewort mittels eines Generatorpolynoms $G(x) = (1+x^c)P(x)$ generiert - wie in Fig. 3 gezeigt und genau wie im Zusammenhang mit dem Stand der Technik erklärt ist.

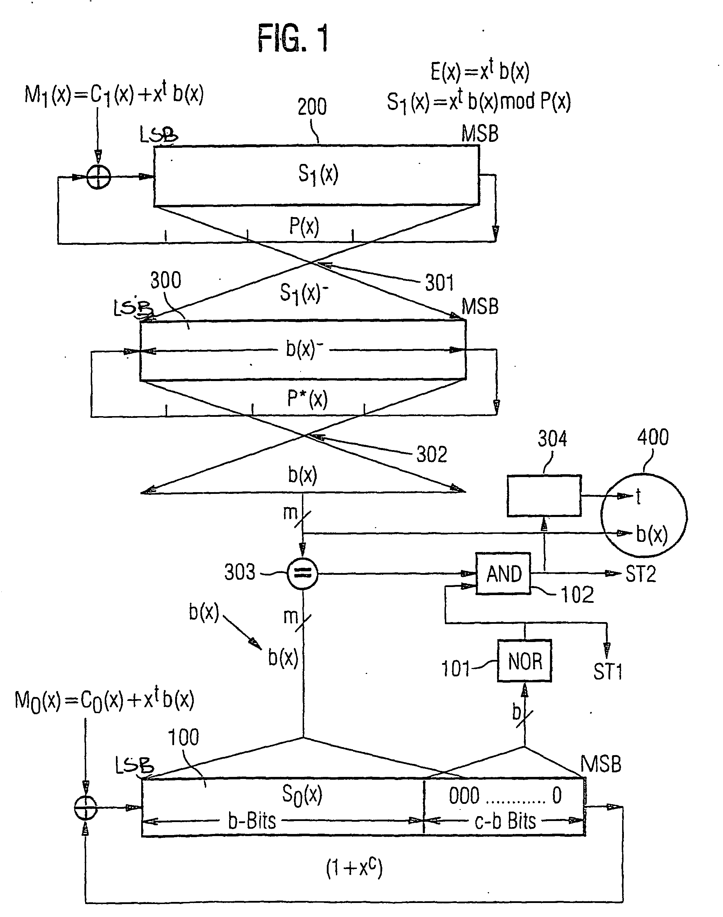

Divisionen der k Datenbits $D(x)$ durch die Polynome $(1+x^c)$ bzw. $P(x)$ ergeben zwei Redundanzwörter $R_0(x)$ und $R_1(x)$ mit c bzw. m Bits, wie in Fig. 3(a) bzw. 1(b) gezeigt. D.h. das Datenwort $D(x)$ wird in die beiden betreffenden Schieberegister gegeben. Nach je k Takten sind diese Register dann im Zustand $R_0(x)$ bzw. $R_1(x)$. Diese Zustände werden nun ausgelesen, indem diese beiden Schieberegister noch c bzw. m Takte getaktet werden (mit Eingang Null).

Wie in Fig. 3(c) dargestellt, ergeben beide Teilredundanzen $R(x)$ bzw. $R_1(x)$ und Datenbits $D(x)$ das systematische Codewort $C(x)$, bestehend aus $r = c + m$ Bits Redundanz und k Bits Daten.

Fig. 1 zeigt eine schematische Darstellung eines Decodierverfahrens als Ausführungsbeispiel der vorliegenden Erfindung.

Der Decodiervorgang auf der Empfängerseite, wie in Fig. 1 illustriert, läuft unter folgenden Schritten ab.

1. Die empfangenen gestörten Codewörter $M_0(x) = C_0(x) + E(x)$ mit k Bits aus Fig. 3(e) bzw. $M_1(x) = C_1(x) + E(x)$ mit k Bits aus Fig. 3(f) werden in beide linear rückgekoppelte Schieberegister 100 bzw. 200 seriell eingegeben. Nach k Takten ergeben sich als Endzustände der beiden Schieberegister 100 und 200 die beiden Fehlersyndrome $S_0(x)$ und $S_1(x)$, wie in Fig. 1 gezeigt.
Eine entsprechend angepaßte Eingabe bei Verwendung von nur einem Redundanzwort bei der Codierung, wie oben erwähnt, ist ebenfalls möglich.

2. Das Schieberegister 100 wird nun mit Eingang = "0" getaktet, bis die letzten c - b Bits alle Null sind. Der Ausgang des NOR-Gatters 101 wird somit "1" und liefert damit das Stop-Signal ST1 für den ersten Suchvorgang hinsichtlich des Musters $b(x)$. Wird diese Bedingung Ausgang des NOR-Gatters 101 ist "1" erfüllt, so liegt das Muster des Fehlerbündels $b(x)$ in den ersten b Bits des Schieberegisters 100 vor. Dieser Vorgang dauert maximal c - 1 Takte. Wird der Suchvorgang in dieser Zeit nicht erfüllt; so liegt ein unkorrigierbarer Fehler vor. Der Decodiervorgang wird dann unterbrochen und ein nicht korrigierbarer Fehler wird gemeldet.

3. Wird Punkt 2 jedoch erfolgreich beendet, so wird anschließend mit Hilfe einer Spiegelungsvorrichtung 301 der gespiegelte Inhalt des Registers 200 in das Register 300 geladen.

4. Die Rückkopplung des Registers 300 ist mit dem Reziprok-Polynom $P^*(x) = x^m \cdot P(1/x)$ (Spiegelbild von $P(x)$) geschaltet. Der Inhalt von Register 300, das eine Breite von m Bits aufweist, wird nun über den Vergleicher 303 mit den ersten m Bits des Registers 100 verglichen. Register 300 wird nun getaktet. Liegt ein korrigierbarer Fehler vor, so werden am Vergleicher 303 nach t Takten zweimal die gleichen Bitmuster anliegen. Die Anzahl der verstrichenen Takte wird von Zähler 304 gezählt. Wenn beide Bitmuster übereinstimmen, dann enthält der Zähler 304 die Fehlerposition t, welche der Anzahl der verstrichenen/gezählten Takte entspricht. Der Fehler kann nun korrigiert werden, da sowohl das Fehlermuster $b(x)$ als auch dessen Position t im empfangenen Signal bekannt sind und am Ausgang 400 vorliegen.

Der Vorgang der Decodierung ist damit erfolgreich beendet. Sollten die beiden Bitmuster am Vergleicher 303 nach maximal k Takten nicht übereinstimmen, so liegt ein nicht korrigierbarer Fehler vor, ist hiermit jedoch als Fehler detektiert/erkannt worden. In diesem Fall wird der Decodiervorgang ebenfalls beendet, es wird allerdings ein nicht korrigierbarer Fehler gemeldet.

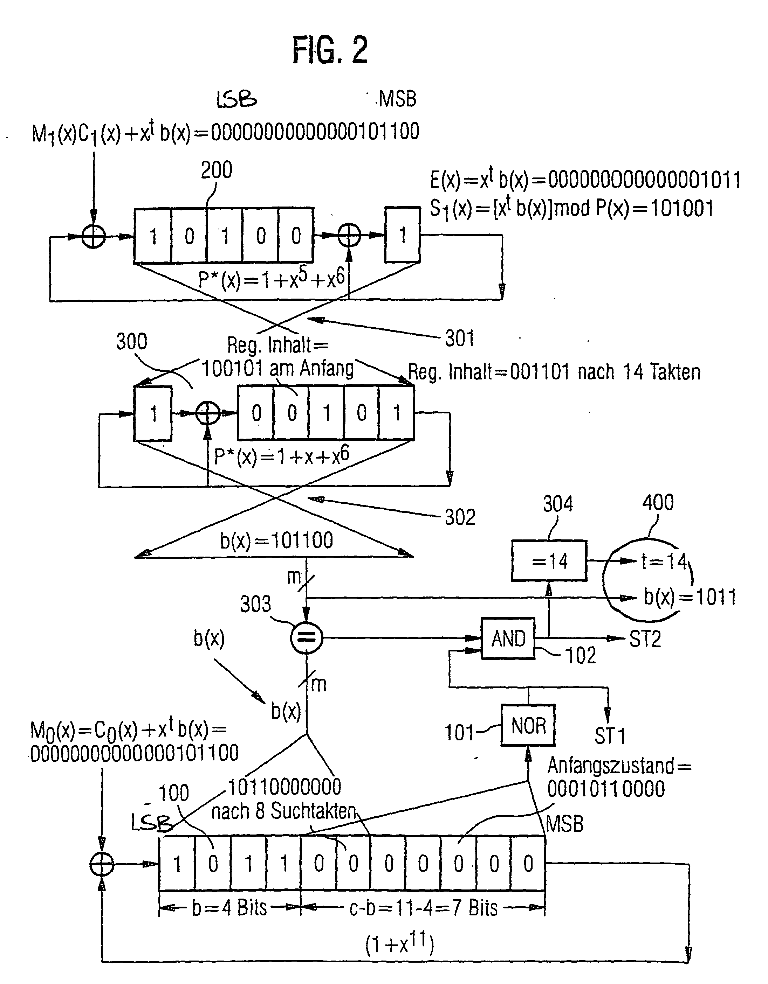

Fig. 2 zeigt eine schematische Darstellung eines konkreten Decodierbeispiels für das Decodierverfahrens nach Fig. 1.

Durch folgendes Beispiel wird die Funktionsfähigkeit des Decodierers plausibel dargestellt.

Der zugrundeliegende Fire-Code sei über folgendes Generatorpolynom definiert:

$$G(x) = (1+x^c) \, P(x) = (1+x^{11}) \, (1 + x^5 + x^6)$$

D.h.

$$c = 11, \, m = 6 \Rightarrow r = c + m = 17$$

$$P(x) = 1 + x^5 + x^6 = 1000011 \qquad \text{(LSB ... MSB)}$$

$$P^*(x) = 1 + x + x^6 = 1100001 \qquad \text{(LSB ... MSB)}$$

Das Fehlermuster wird als $E(x) = x14 \, (1 + x^2 + x^3) = 00000000000000101100$ (LSB ... MSB) angenommen,

$$\text{d.h. } t = 14, \, b(x) = 1 + x^2 + x^3 = 1011 \qquad \text{(LSB ... MSB)}$$

Ohne Beschränkung der Allgemeinheit kann als Datenwort $D(x)$ das Nullwort bestehend aus k = 20 Nullen betrachtet werden (also $D(x) = 0$) oder $D(x) = 00000000000000000000$.

Die empfangenen gestörten Teilcodewörter $M_0(x)$ bzw. $M_1(x)$ der Länge k = 20 Bits sind somit identisch mit dem Fehlermuster $E(x)$, da $R_0(x) = R_1(x) = C_1(x) = C_0(x) = 0$.

Dieses sei gegeben durch:

$$M_0(x) = C_0(x) + E(x) = E(x) = x^{14}(1 + x^2 + x^3) =$$

$$00000000000000101100 \qquad \text{(LSB ... MSB)}$$

bzw.

$$M_1(x) = C_1(x) + E(x) = E(x) = x^{14}(1 + x^2 + x^3) =$$

$$00000000000000101100 \qquad \text{(LSB ... MSB)}$$

Zur Syndrom-Generierung wird zunächst das empfangene, gestörte Codewort (hier: $M_0(x) = M_1(x) = E(x)$) in die Schieberegister 100 bzw. 200 geschrieben, wobei das MSB zuerst eingelesen wird. Nach k = 20 Takten steht im Register 100 der Inhalt 000101100000, d.h. das Syndrom $S_0(x)$ lautet:

$$S_0(x) = 00010110000 \qquad \text{(LSB ... MSB)}$$

Ebenfalls nach k = 20 Takten steht im Register 200 das Syndrom $S_1(x)$:

$$S_1(x) = 101001 \qquad \text{(LSB ... MSB)}$$

In einem ersten Suchvorgang wird das Register 100 solange getaktet, bis die letzten c-b = 11-4 = 7 Bit gleich Null sind. Dafür benötigt man in diesem Fall 8 Takte. Damit steht in den ersten LSB-Bits vom Register 100 das Fehlermuster b(x) = 1011.

In einem zweiten Suchvorgang wird in das Register 300 nun das Spiegelbild des Syndroms $S_1(x)$ geladen, das sich in Register 200 befindet. Der Registerinhalt von Register 200 ist somit = 100101.

Das Spiegelbild des Inhalts des Registers 300 wird von jetzt an ständig mit den "untersten" m Bits (von LSB bis LSB + m - 1) des Registers 100 verglichen. Register 300, das mit dem Spiegelbild von P(X) beschaltet ist, wird nun getaktet, während der Zähler 304 die verstrichene Zeit (Takte) mitzählt und der Vergleicher 303 beide Bitmuster miteinander vergleicht.

Nach 14 Takten stimmt das Spiegelbild des Inhalts in Schieberegister 300 mit den m "untersten" Bits aus Schieberegister 100 (101100), dem Fehlermuster b(x) überein, d.h. die Fehlerposition ist gefunden. Man erhält t = 14 und b(x) = 101100 am Ausgang 400. Modulo 2 Addition von $E(x) = x^t \cdot b(x) = x^{14} \cdot (1 + x^2 + x^3)$ mit dem empfangenen (gestörten) Datenwort liefert das korrigierte Datenwort.

Obwohl die vorliegende Erfindung vorstehend anhand eines bevorzugten Ausführungsbeispiels beschrieben wurde, ist sie darauf nicht beschränkt, sondern auf vielfältige Weise modifizierbar.

Insbesondere ist die Erfindung auf jegliche Art digitaler Datenübertragung geeignet.

Falls das Polynom P(x) selbstreziprok ist, d.h. P(x) = P*(x), dann entfällt die Notwendigkeit für das Register 300, in das der gespiegelte Inhalt des Registers 200 eingelesen wird. Diese Implementierung ist hardwaremäßig besonders interessant.

**Patentansprüche**

1. Datenübertragungsvorrichtung zur Durchführung einer VRC-Datenübertragungstechnik, wobei VRC Variable Redundancy Codes bezeichnet mit:

   einer Sendeeinrichtung mit einer Codiereinrichtung zum Erzeugen eines Codewortes (C) aus einem Datenwort (D) und einem Fire-Code, welcher über ein Generatorpolynom (G) definierbar ist;

   einer Einrichtung zum Übertragen des Codewortes (C) von der Sendeeinrichtung zu einer Empfangseinrichtung, wobei das an der Empfangseinrichtung empfangene Signal (M) als eine Superposition des Codewortes (C) und eines Fehlerwortes (E) darstellbar ist;

   einer in der Empfangseinrichtung vorgesehenen Decodiereinrichtung zum Erzeugen des Datenwortes (D) aus dem empfangenen Signal (M); und

   einer in der Empfangseinrichtung vorgesehenen Fehlersucheinrichtung zum Suchen eines dem Fehlerwort (E) entsprechenden Fehlermusters (b) und der zugehörigen Position (t);

   **dadurch gekennzeichnet, dass**
   die in der Empfangseinrichtung vorgesehene Decodiereinrichtung eine Einrichtung zur Generierung des Syndroms ($S_1$) mittels eines irreduziblen Teilpolynoms P(x) das ein Faktor des Generatorpolynoms (G) ist, und eine Spiegelungsvorrichtung (301) zur Spiegelung des Syndroms ($S_1$) zur Verwendung des gespiegelten Syndroms ($\bar{S}_1$) in der Fehlersucheinrichtung aufweist, wobei bei der Spiegelung des Syndroms ($S_1$) die Reihenfolge der Stellen des Syndroms ($S_1$) von der niederwertigsten Stelle (LSB) zur höchstwertigen Stelle (MSB) vertauscht wird.

2. Datenübertragungsvorrichtung nach Anspruch 1, **dadurch gekennzeichnet, dass** in der Empfangseinrichtung eine Vergleichseinrichtung zum Vergleichen des Fehlermusters (b) mit dem Spiegelbild des Inhalts eines Registers (300), das mit dem gespiegelten Syndrom ($\bar{S}_1$) vorbelegt ist, wobei das Spiegelbild des Teilpolynoms (P*) als Rückkopplung oder Beschaltung des Registers (300) vorgesehen ist, um die Position (t) des Fehlermusters (b) durch den Vergleich zu identifizieren.

3. Datenübertragungsvorrichtung nach Anspruch 1 oder 2, **dadurch gekennzeichnet, dass** in der Empfangseinrichtung ein erstes Schieberegister (200) zum Generieren des Syndroms ($S_1$), und ein zweites Schieberegister (300) zum Generieren eines weiteren Syndroms oder Bitmusters aus dem gespiegelten Syndrom ($\bar{S}_1$) enthalten sind.

4. Datenübertragungsvorrichtung nach Anspruch 1, **dadurch gekennzeichnet, dass** das Teilpolynom P(x) selbstreziprok ist und dass in der Empfangseinrichtung ein und dasselbe Schieberegister (200) zum Generieren des Syndroms ($S_1$) und eines weiteren Syndroms oder Bitmusters aus dem gespiegelten Syndrom ($\bar{S_1}$) enthaltern ist.

5. Datenübertragungsvorrichtung nach einem der vorhergehenden Ansprüche, **dadurch gekennzeichnet, dass** die Codiereinrichtung derart gestaltet ist, dass eine Einschränkung der Länge des Codewortes (C) auf die Länge e der Periode des Teilpolynoms (P) vorgesehen ist.

6. Datenübertragungsvorrichtung nach einem der vorhergehenden Ansprüche, **dadurch gekennzeichnet, dass** die Codiereinrichtung derart gestaltet ist, dass für den Codeparameter c im Fire-Code-Gerieratorpolynom G(x), das definiert ist durch G(x)= (1 + $x^c$) * P(x), c ≥ 2 * b - 1 gilt, wobei b die Länge eines Bündelfehlers darstellt, der noch mit Hilfe dieses Codes korrigiert werden kann und maximal den Wert m annehmen kann, wobei m der Grad des Teilpolynoms (P) ist.

7. Datenübertragungsverfahren zur Durchführung einer VRC-Datenübertragungstechnik, wobei VRC Variable Redundancy Codes bezeichnet mit den Schritten:

    Erzeugen eines Codewortes (C) aus einem Datenwort (D) und einem Fire-Code, welcher über ein Generatorpolynom (G) definierbar ist, in einer Sendeeinrichtung mit einer Codiereinrichtung;

    Übertragen des Codewortes (C) von der Sendeeinrichtung zu einer Empfangseinrichtung, wobei das an der Empfangseinrichtung empfangene Signal (M) als eine Superposition des Codewortes (C) und eines Fehlerwortes (E) darstellbar ist;

    Erzeugen des Datenwortes (D) aus dem empfangenen Signal (M) in einer in der Empfangseinrichtung vorgesehenen Decodiereinrichtüng; und

    Suchen eines dem Fehlerwort (E) entsprechenden Fehlermusters (b) und der zugehörigen Position (t) in einer in der Empfangseinrichtung vorgesehenen Fehlersucheinrichtung;

    **gekennzeichnet durch** die Schritte
Generieren des Syndroms ($S_1$) mittels eines irreduziblen Teilpolynoms P(x), das ein Faktor des Generatorpolynoms (G) ist, und Spiegeln des Syndroms ($S_1$) zur Verwendung des gespiegelten Syndroms ($\bar{S_1}$) in der Fehlersucheinrichtung in der in der Empfangseinrichtung vorgesehenen Decodiereinrichtung, wobei bei der Spiegelung des Syndroms ($S_1$) die Reihenfolge der Stellen des Syndroms ($S_1$) von der niederwertigsten Stelle (LSB) zur höchstwertigen Stelle (MSB) vertauscht wird.

8. Datenübertragungsverfahren nach Anspruch 7, **dadurch gekennzeichnet, dass** in der Empfangseinrichtung ein Vergleich des Fehlermusters (b) mit dem Spiegelbild des Inhalts eines Registers (300), das mit dem gespiegelten Syndrom ($\bar{S_1}$) vorbelegt ist, durchgeführt wird, wobei das Spiegelbild des Teilpolynoms (P*) als Rückkopplung oder Beschaltung des Registers (300) vorgesehen wird, um die Position (t) des Fehlermusters (b) durch den Vergleich zu identifizieren.

9. Datenübertragungsverfahren nach Anspruch 7 oder 8, **dadurch gekennzeichnet, dass** die Codiereinrichtung eine Einschränkung der Länge des Codewortes (C) auf die Länge e der Periode des Teilpolynoms (P) durchführt.

10. Datenübertragungsverfahren nach Anspruch 7, 8 oder 9, **dadurch gekennzeichnet, dass** die Codiereinrichtung für den Codeparameter c im Fire-Code-Generatorpolynom G(x), das definiert ist durch G(x) = (1 + $x^c$) * P(x) c ≥ 2 * b - 1 vorsieht, wobei b die Länge eines Bündelfehlers darstellt, der noch mit Hilfe dieses Codes korrigiert werden kann und maximal den Wert m annehmen kann, wobei m der Grad des Teilpolynoms (P) ist.

**Claims**

1. Data transmission apparatus for carrying out a VRC data transmission technique, VRC denoting Variable Redundancy Codes, having:

    a transmitting device with a coding device for generating a code word (C) from a data word (D) and a fire code which can be defined via a generator polynomial (G);

a device for transmitting the code word (C) from the transmitting device to a receiving device, it being possible for the signal (M) received at the receiving device to be represented as a superposition of the code word (C) and an error word (E);

a decoding device provided in the receiving device for the purpose of generating the data word (D) from the received signal (M); and

an error search device, provided in the receiving device, for searching for an error pattern (b) corresponding to the error word (E), and for the associated position (t);

**characterized in that**
the decoding device provided in the receiving device has a device for generating the syndrome ($S_1$) by means of an irreducible partial polynomial P(x), which is a factor of the generator polynomial (G), and has a reflecting apparatus (301) for reflecting the syndrome ($S_1$) in order to use the reflected syndrome ($\bar{S_1}$) in the error search device, the sequence of the positions of the syndrome ($S_1$) being exchanged from the least significant bit (LSB) to the most significant bit (MSB) during reflection of the syndrome ($S_1$).

2. Data transmission apparatus according to Claim 1, **characterized in that** a comparator device is provided in the receiving device in order to compare the error pattern (b) with the mirror image of the contents of a register (300) to which the reflected syndrome ($\bar{S_1}$) has been preallocated, the mirror image of the partial polynomial (P*) being provided as feedback or wiring of the register (300) in order to identify the position (t) of the error pattern (b) by means of the comparison.

3. Data transmission apparatus according to Claim 1 or 2, **characterized in that** the receiving device includes a first shift register (200) for generating the syndrome ($S_1$), and a second shift register (300) for generating a further syndrome or bit pattern from the reflected syndrome ($\bar{S_1}$).

4. Data transmission apparatus according to Claim 1, **characterized in that** the partial polynomial P(x) is self-reciprocal, and **in that** one and the same shift register (200) is included in the receiving device for the purpose of generating the syndrome ($S_1$) and a further syndrome or bit pattern from the reflected syndrome $\bar{S_1}$.

5. Data transmission apparatus according to one of the preceding claims, **characterized in that** the coding device is configured in such a way as to provide a restriction of the length of the code word (C) to the length e of the period of the partial polynomial (P).

6. Data transmission apparatus according to one of the preceding claims, **characterized in that** the coding device is configured in such a way that it holds for the code parameter c in the fire code generator polynomial G(x), which is defined by G(x)=$(1 + x^c)$*P(x), that c $\geq$ 2 * b - 1, b representing the length of a burst error which can still be corrected with the aid of this code and can assume at most the value m, m being the degree of the partial polynomial (P).

7. Data transmission method for carrying out a VRC data transmission technique, VRC denoting Variable Redundancy Codes, having the steps of:

generating a code word (C) from a data word (D) and a fire code which can be defined via a generator polynomial (G), in a transmitting device with a coding device;

transmitting the code word (C) from the transmitting device to a receiving device, it being possible for the signal (M) received at the receiving device to be represented as a superposition of the code word (C) and an error word (E);

generating the data word (D) from the received signal (M) in a decoding device provided in the receiving device; and

searching for an error pattern (b) corresponding to the error word (E), and for the associated position (t) in an error search device provided in the receiving device;

**characterized by** the steps of

generating the syndrome ($S_1$) by means of an irreducible partial polynomial P(x), which is a factor of the generator polynomial (G), and reflecting the syndrome ($S_1$) in order to use the reflected syndrome ($\bar{S_1}$) in the error search device in the decoding device provided in the receiving device, the sequence of the positions of the syndrome ($S_1$) being exchanged from the least significant bit (LSB) to the most significant bit (MSB) during the reflection of the syndrome ($S_1$).

8. Data transmission method according to Claim 7, **characterized in that** a comparison of the error pattern (b) with the mirror image of the contents of a register (300) to which the reflected syndrome ($\bar{S_1}$) has been preallocated is carried out in the receiving device, the mirror image of the partial polynomial (P*) being provided as feedback or configuration of the register (300) in order to identify the position (t) of the error pattern (b) by means of the comparison.

9. Data transmission method according to Claim 7 or 8, **characterized in that** the coding device carries out a restriction of the length of the code word (C) to the length e of the period of the partial polynomial (P).

10. Data transmission method according to Claim 7, 8 or 9, **characterized in that** the coding device provides for the code parameter c in the fire code generator polynomial G(x), which is defined by G(x)=(1 + x$^c$)*P(x), that c $\geq$ 2 * b - 1, b representing the length of a burst error which can still be corrected with the aid of this code and can assume at most the value m, m being the degree of the partial polynomial (P).

**Revendications**

1. Dispositif de transmission de données pour appliquer une technique de transmission de données VRC, c'est-à-dire avec des codes à redondance variable, comprenant :

   - une installation d'émission ayant une installation de codage pour générer un mot de code (C) à partir d'un mot de données (D) et d'un code barrière défini par un polynôme générateur (G),
   - une installation pour transmettre le mot de code (C) de l'installation d'émission à l'installation de réception, le signal (M) reçu par l'installation d'émission étant représenté comme superposition du mot de code (C) et d'un mot d'erreur (E),
   - une installation de décodage dans l'installation de réception pour générer le mot de données (D) à partir du signal reçu (M) et
   - une installation de recherche d'erreurs dans l'installation d'émission pour rechercher un modèle d'erreurs (b) correspondant au mot d'erreur (E) et la position correspondante (t),

   **caractérisé en ce que**
   l'installation de décodage de l'installation de réception comprend une installation pour générer le syndrome ($S_1$) à l'aide d'un polynôme partiel irréductible P(x), facteur du polynôme générateur (G), et une installation miroir (301) qui forme l'image miroir du syndrome ($S_1$) pour utiliser le syndrome image ($\bar{S}_1$) dans l'installation de recherche d'erreurs, et pour former l'image du syndrome ($S_1$) on échange l'ordre des positions du syndrome ($S_1$) en allant de la position de poids le plus faible (LSB) vers la position de poids le plus élevé (MSB).

2. Dispositif de transmission de données selon la revendication 1,
   **caractérisé en ce que**
   l'installation de réception comprend une installation de comparaison pour comparer le modèle d'erreurs (b) à l'image miroir du contenu d'un registre (300) occupé par le syndrome image ($\bar{S}_1$), l'image miroir du polynôme partiel (P*) étant prévue comme réaction ou connexion du registre (300) pour identifier par la comparaison la position (t) du modèle d'erreurs (b).

3. Dispositif de transmission de données selon la revendication 1 ou 2,
   **caractérisé en ce que**
   l'installation de réception comprend un premier registre à décalage (200) pour générer le syndrome ($S_1$) et un second registre à décalage (300) pour générer un autre syndrome ou modèle de bits à partir du syndrome image ($\bar{S}_1$).

4. Dispositif de transmission de données selon la revendication 1,

**caractérisé en ce que**
le polynôme partiel P(x) est autoréciproque et l'installation de réception comprend un seul et même registre à décalage (200) pour générer le syndrome ($S_1$) et un autre syndrome ou modèle de bits à partir du syndrome image ($\bar{S}_1$).

5. Dispositif de transmission de données selon l'une des revendications précédentes,
**caractérisé en ce que**
l'installation de codage est formée pour limiter la longueur du mot de code (C) sur la longueur « e » de la période du polynôme partiel (P).

6. Dispositif de transmission de données selon l'une des revendications précédentes,
**caractérisé en ce que**
l'installation de codage est conçue pour que le paramètre de code « c » du polynôme générateur de code barrière G(x) qui est défini par la relation G(x) = (1 + $x^c$) * P(x), réponde à la relation c ≥ 2 * b - 1,
(b) étant la longueur d'une erreur de regroupement que l'on corrige à l'aide de ce code et qui prend au maximum la valeur (m), degré du polynôme partiel (P).

7. Procédé de transmission de données pour appliquer une technique de transmission de données VRC, c'est-à-dire des codes à redondance variable, comprenant les étapes suivantes :

   - formation d'un mot de code (C) à partir d'un mot de données (D) et d'un code barrière défini par un polynôme générateur (G) dans une installation d'émission avec une installation de codage,
   - transmission du mot de code (C) par l'installation d'émission vers l'installation de réception, le signal (M) reçu par l'installation de réception étant présenté comme superposition du mot de code (C) et d'un moteur d'erreur (E),
   - formation du mot de données (D) à partir du signal (M) reçu dans une installation de décodage de l'installation de réception et
   - recherche d'un modèle d'erreurs (b) correspondant au mot d'erreur (E) et de la position correspondante (t) dans une installation de recherche d'erreurs de l'installation de réception,

   **caractérisé par** les étapes suivantes :

   - génération du syndrome ($S_1$) à l'aide d'un polynôme partiel irréductible P(x) qui est un facteur du polynôme générateur (G) et, pour utiliser le syndrome image ($\bar{S}_1$) dans l'installation de recherche d'erreurs, formation de l'image miroir du syndrome ($S_1$) dans l'installation de décodage de l'installation de réception,
   - et pour former l'image miroir du syndrome ($S_1$), on échange l'ordre des positions du syndrome ($S_1$) entre les positions de poids le plus faible (LSB) et les positions de poids le plus élevé (MSB).

8. Procédé de transmission de données selon la revendication 7,
**caractérisé en ce que**
dans l'installation de réception on effectue une comparaison du modèle d'erreurs (b) avec l'image miroir du contenu d'un registre (300) occupé par le syndrome image ($\bar{S}_1$),
l'image miroir du polynôme partiel (P*) étant prévue comme réaction ou connexion du registre (300) pour identifier par la comparaison la position (t) du modèle d'erreurs (b).

9. Procédé de transmission de données selon la revendication 7 ou 8,
**caractérisé en ce que**
l'installation de codage exécute une limitation de la longueur du mot de code (C) sur la longueur (e) de la période du polynôme partiel (P).

10. Procédé de transmission de données selon les revendications 7, 8 ou 9,
**caractérisé en ce que**
l'installation de codage assure que dans le polynôme générateur du code barrière G(x), lui-même défini par la relation G(x) = (1 + $x^c$) * P(x), le paramètre « c » réponde à la relation c ≥ 2 * b - 1, b étant la longueur de l'erreur de regroupement que l'on corrige à l'aide de ce code et qui peut prendre au maximum la valeur (m), degré du polynôme partiel (P).

# FIG. 1

$M_1(x) = C_1(x) + x^t b(x)$

$E(x) = x^t b(x)$

$S_1(x) = x^t b(x) \bmod P(x)$

LSB     200     MSB

$S_1(x)$

$P(x)$

300     $S_1(x)^-$     301

LSB     MSB

$b(x)^-$

$P^*(x)$

302     304     400

$b(x)$

t

m

b(x)

303   =    AND    ST2

102

$b(x)$

m

b(x)

NOR

101

ST1

b/

$M_0(x) = C_0(x) + x^t b(x)$

100

LSB     MSB

$S_0(x)$     000 ............ 0

b-Bits     c-b Bits

$(1 + x^c)$

# FIG. 2

LSB            MSB

$M_1(x)C_1(x) + x^t b(x) = 00000000000000101100$

$E(x) = x^t b(x) = 000000000000001011$
$S_1(x) = [x^t b(x)] \bmod P(x) = 101001$

200

| 1 | 0 | 1 | 0 | 0 |
|---|---|---|---|---|

| 1 |
|---|

$P^*(x) = 1 + x^5 + x^6$

301

Reg. Inhalt =
100101 am Anfang

Reg. Inhalt = 001101 nach 14 Takten

300

| 1 |
|---|

| 0 | 0 | 1 | 0 | 1 |
|---|---|---|---|---|

$P^*(x) = 1 + x + x^6$

302

$b(x) = 101100$

m

303

b(x)

$M_0(x) = C_0(x) + x^t b(x) =$
00000000000000101100

m

b(x)

304     400

| = 14 |
|---|

t = 14
b(x) = 1011

AND    ST2
102

NOR
101     ST1

Anfangszustand =
00010110000

100
10110000000
nach 8 Suchtakten

LSB           MSB

| 1 | 0 | 1 | 1 | 0 | 0 | 0 | 0 | 0 | 0 | 0 |
|---|---|---|---|---|---|---|---|---|---|---|

b = 4 Bits     c-b = 11-4 = 7 Bits

$(1 + x^{11})$

# FIG. 3

(a)

$D(x)$

LSB $\qquad$ MSB

$R_0(x)$

$(1+x^c)$

(b)

$D(x)$

LSB $\qquad$ MSB

$R_1(x)$

$P(x)$

(c)

LSB $\qquad$ MSB

| $R_0(x)$ c Bits | $R_1(x)$ c Bits | $D(x)$ k Bits |

$C(x)$

(d)

$$M(x) = C(x) + E(x)$$

(e) $C_0(x) =$

$\leftarrow$ k Bits $\rightarrow$

LSB $\qquad$ MSB

$R_0(x)$ $\qquad$ $D(x)$

$C_0(x), M_0(x):$ $C_0(x) = R_0(x) + D(x)$

$M_0(x) = C_0(x) + E(x)$

(f) $C_1(x) =$

$\leftarrow$ k Bits $\rightarrow$

LSB $\qquad$ MSB

$R_1(x)$ $\qquad$ $D(x)$

$C_1(x), M_1(x):$ $C_1(x) = R_1(x) + D(x)$

$M_1(x) = C_1(x) + E(x)$

# FIG 4

$E(x) = x^t\, b(x)$

$M_1(x) = C_1(x) + x^t\, b(x)$

$S_1(x) = x^t\, b(x) \bmod P(x)$

$S_1(x)$

$P(x)$

$b(x)$

$C_2$   L2

$C_1$   L1

$\underline{60}$   t

$b(x)$

$M_0(x) = C_0(x) + x^t\, b(x)$

LSB   30

$b(x)$

000 . . . 0

NOR   50

MSB

$(1 + x^c)$